# EUROPEAN PATENT APPLICATION

(11) **EP 0 711 846 A1**
(43) Date of publication of application: **15.05.1996**
(21) Application number: 95307620.5
(22) Date of filing: 26.10.1995
(51) Int. Cl.: C23C 16/34, C23C 16/56, H01L 21/00

(54) **Titanium nitride deposited by chemical vapor deposition**

(30) Priority: 14.11.1994 US 339521
(71) Applicant: APPLIED MATERIALS, INC., Santa Clara California 95054-3299 (US)
(72) Inventor: Mosely, Roderick C., Pleasanton, California 94588 (US); Littau, Karl A., Palo Alto, California 94303 (US); Raaijmakers, Ivo, San Jose, California 95125 (US)
(74) Representative: Allard, Susan Joyce

(57) **Abstract**

Properties of films deposited by chemical vapor deposition onto a substrate can be modified by treating them in a plasma of a gas while applying a bias voltage to the substrate. In the case of titanium nitride, the density of the films are increased and the sheet resistivity decreased and stabilized.

## Description

This invention relates to a method for improving the properties of thin films. More particularly, this invention relates to a method of densifying and stabilizing the resistivity of titanium nitride films.

Titanium nitride has found utility in the manufacture of semiconductor devices, particularly as barrier layers between a semiconductor substrate, e.g., a silicon wafer, and conductive layers from which contacts are made. For example, a thin barrier layer of titanium nitride can be deposited by nitriding from a titanium metal layer, or deposited by sputtering into an opening in a silicon oxide layer, and a conductive metal layer is then deposited thereover. The titanium nitride barrier layer prevents diffusion of dissimilar materials, such as a silicon substrate and an overlying aluminum contact layer. In addition, it is a good chemical barrier to gas phase species, such as tungsten hexafluoride, used in tungsten deposition processes.

Titanium nitride is also useful because it has a low bulk resistivity and makes excellent ohmic contact with conductive layers. Further, it has good adhesion to conductive metal layers, such as an overlying tungsten layer, and insulators.

Titanium nitride barrier layers have been formed in a preferred method by sputtering titanium metal in a nitrogen environment, forming titanium nitride on the wafer surface or contact openings. A heating step drives the reaction of the titanium with an underlying silicon layer to form the corresponding ohmic contact material, titanium silicide. However, as semiconductor devices become smaller and more devices are found on a single substrate, it is more difficult to deposit conformal layers either by sputtering titanium or reactive sputtering of titanium nitride into small openings having a high aspect ratio, and to cover stepped topography, without leaving voids.

Thus directly depositing titanium nitride in the opening by chemical vapor deposition has also been tried.

Sandhu et al, see US Patent 5,246,881, have disclosed a chemical vapor deposition method for depositing titanium nitride films. A metallo-organic titanium compound having the formula Ti(NR₂)₄ wherein R is an alkyl group, is readily decomposed at comparatively low temperatures of 200-600°C under vacuum pressures of about 0.1-100 Torr to deposit titanium nitride in a highly conformal manner. This method has the advantage of good deposition rates, excellent conformality and step coverage, and good particle performance, and the resultant titanium nitride layer has good barrier properties. This method is also low in cost. However, the resistivity of the titanium nitride film is high and unstable. Over time the resistivity increases to such an extent that the film is no longer usable for semiconductor devices.

In an effort to reduce the resistivity, Sandhu et al added a Lewis base during deposition of the titanium nitride film. Suitable Lewis bases include chlorine, NF₃ or NH₃ for example. The bulk resistivity was reduced, but the titanium nitride films contained additional contaminants such as halogens. Also special care must be taken to separately deliver the several precursor gases to the reaction chamber.

Wanne in US Patent 5,273,783 has disclosed another chemical vapor deposition method of depositing titanium nitride using a different organometallic titanium compound, bis(2,4-dimethylpentadienyl)titanium. Titanium metal can be deposited from this compound, or a nitrogen-containing Lewis base, such as NH₃, can be added to form titanium nitride, but again, contaminated films are obtained.

Thus a method of treating a titanium nitride film deposited by chemical vapor deposition that will modify the film to reduce its resistivity and improve its stability would be highly desirable.

We have found that a post treatment of films formed via chemical vapor deposition by exposure of the deposited film to an inert plasma while biasing the substrate, results in more stable films. In particular, titanium nitride films formed by chemical vapor deposition from a metallo-organotitanium compound are modified to improve the resistivity and the stability of the films. We believe that biasing the substrate in the plasma bombards the surface of the films with high energy ions that densify the film, and in turn reduce the absorption of oxygen by the film after exposure to the atmosphere.

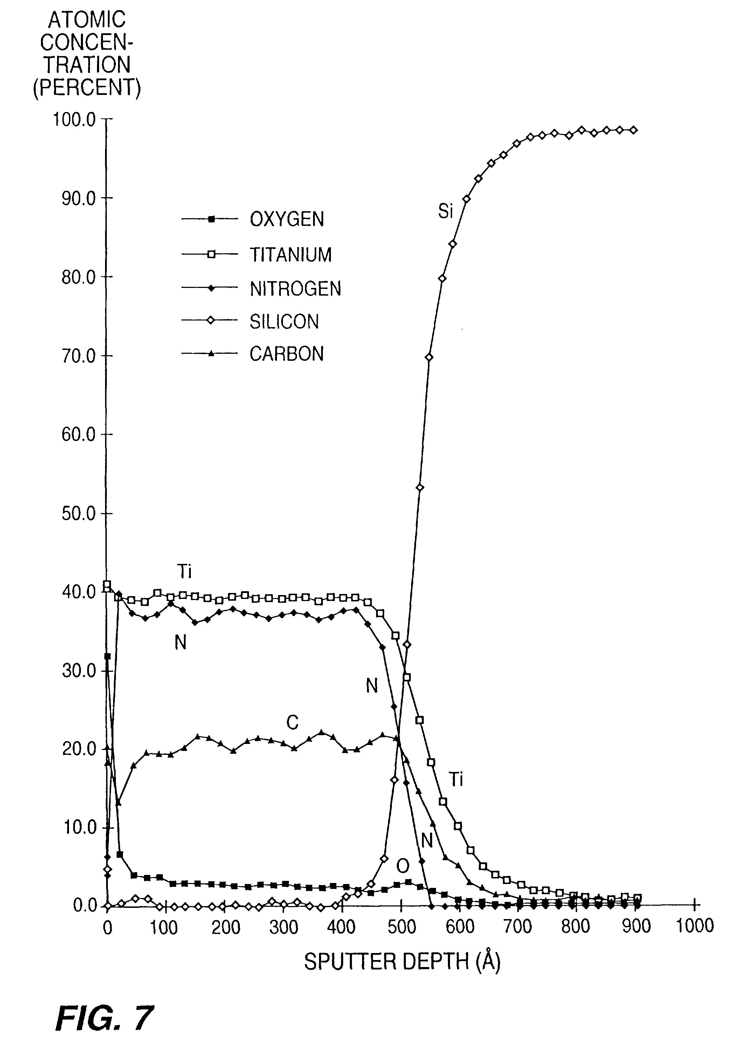

The present invention will be further described with reference to Figures 1 to 12 of the accompanying drawings in which:

Fig. 1 is a schematic diagram of a chemical vapor deposition chamber in which the present deposition and post deposition treatment process can be carried out.

Fig. 2 is a graph of sheet resistivity versus time of titanium nitride films deposited in accordance with a standard prior art deposition process.

Fig. 3 is a Rutherford backscattering (RBS) spectrum of a chemical vapor deposited titanium nitride film deposited on a silicon wafer in accordance with the standard prior art deposition process.

Fig. 4 is an RBS spectrum of a chemical vapor deposited titanium nitride film deposited using a gas flow of NF₃.

Fig. 5 is a graph of the atomic concentration in percent of various elements versus sputter depth in angstroms of an Auger sputter analysis of a titanium nitride film of the invention.

Fig. 6 is an Auger surface spectrum of elements of another titanium nitride film of the invention.

Fig. 7 is a graph of the atomic concentration in percent of various elements versus sputter depth in angstroms of the titanium nitride film of Fig. 6.

Fig. 8 is an Auger surface spectrum of elements of a Control titanium nitride film.

Fig. 9 is a graph of the atomic concentration in percent of various elements versus sputter depth in angstroms of the Control titanium nitride film of Fig. 8.

Fig. 10 is an Auger surface spectrum of elements of another titanium nitride film of the invention.

Fig. 11 is a graph of the atomic concentration in percent of various elements versus sputter depth in angstroms of the titanium nitride film of Fig. 10.

Fig. 12 is a schematic view of a multichamber processing apparatus in which the present process can be carried out.

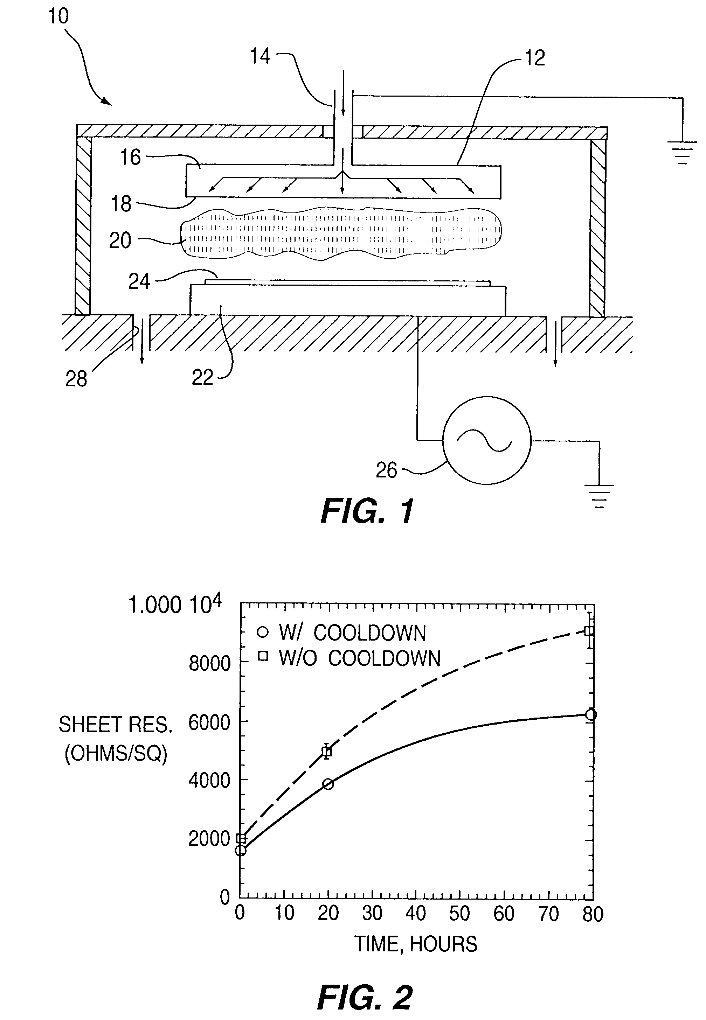

Fig. 1 is a schematic diagram of a chemical vapor deposition (CVD) apparatus in which the present processes can be carried out.

Referring to Fig. 1, a vacuum chamber 10 includes two electrodes. A first gas inlet electrode 12 comprises a precursor gas inlet pipe 14 for entry of one or more precursor and treatment gases into the vacuum chamber. The gas inlet pipe 14 is connected to a chamber 16 wherein the precursor gases are admixed if required, and from which they pass through a plate 18 having a plurality of openings. The precursor gases thus pass into a space 20. The gas inlet electrode 12 is connected to ground.

A second substrate support electrode 22 for supporting and heating a substrate 24 to be coated, is mounted opposite and parallel to the gas manifold plate 18. The support electrode 22 is connected to a source of RF power 26, e.g., 13.56 MHZ. When the power source 26 is turned on during the post deposition treatment step, as further described hereinbelow, a plasma is generated in the space 20 between the electrodes 12 and 22. The spacing between the electrodes 12 and 22 is adjustable. An exhaust pipe 28 maintains pressure in the chamber 10.

The present titanium nitride films are made by chemical vapor deposition starting with an organometallo titanium compound, preferably tetrakisdialkylamido titanium (Ti(NR₂)₄) having the structural formula 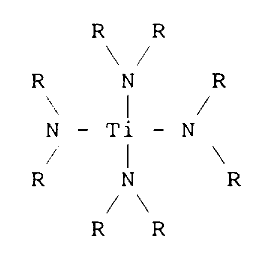 wherein R at each occurrence independently is an alkyl group, preferably of 1-5 carbon atoms. A carrier gas, as of helium, argon, nitrogen, hydrogen and the like, for the above compound brings the compound into the chamber of Fig. 1 where it is reacted with remotely generated reactive species, such as of halogen, ammonia or hydrogen radicals and the like, at a substrate temperature of about 200-600°C and at a pressure of about 0.1-100 Torr, to deposit titanium nitride. The titanium nitride obtained contains significant amounts of carbon, and the resultant titanium nitride films are chemically reactive. Thus when the films are exposed to air or other oxygen-containing gas, oxygen is absorbed and the films then contain both carbon and oxygen as impurities. Since the oxygen absorption is uncontrolled, the stability of the films is impaired, which adversely affects the resistivity of the film in particular, in addition to possibly impairing the reliability of devices made from the films. After exposure to air, the sheet resistivity of these titanium nitride films can increase to values of about 10,000 µohms-cm/sq up to about 100,000 µohms-cm/sq, which is highly undesirable when using the film as a barrier layer for conductive contacts and vias. For that application, stable sheet resistivities on the order of about 1000 µohms-cm/sq or less are desired.

In accordance with the process of the present invention, films of titanium nitride are post treated with an inert plasma containing high energy ions, obtained by applying a DC bias voltage to the substrate. Only a low power RF level need be applied, i.e., sufficient power to form a plasma from a precursor gas, and a voltage of about 100 to 1000 volts applied to the substrate. For example, a voltage of about 400 volts while applying only 100 watts of RF power to form a plasma is quite sufficient to produce high energy ions and to passivate or densify a titanium nitride film so that it remains stable over time.

Although the exact mechanism of the present invention is not known, we believe the high energy ion bombardment of the films on a biased substrate densifies the films. When treated titanium nitride films are later exposed to air, water vapor or oxygen, the oxygen is not absorbed, or is absorbed to a much lesser extent than when no bias voltage has been applied. Thus the treated titanium nitride films of the invention are more crystalline, contain more nitrogen, and have reduced oxygen and carbon content over untreated titanium nitride films produced by conventional thermal chemical vapor deposition of organometallic titanium compounds. The titanium nitride films of the invention have a low, stable sheet resistivity.

The precursor gas used to form the plasma for the post deposition treatment step described herein can be any gas, but is preferably a non-oxygen-and-carbon-containing gas, such as nitrogen, ammonia, argon and the like. Nitrogen is most effective for passivation of the titanium nitride film. Alternatively, the film can be bombarded with ions generated from a non-gaseous species, e.g., ion sources. This plasma treatment step does not adversely affect particle performance, step coverage, deposition rate or barrier performance of the deposited film, but does markedly reduce the absorption of oxygen by the film and stabilizes the resistivity of a titanium nitride film.

Following recommended prior art process parameters, control titanium nitride films were deposited on a silicon wafer under the following conditions in a conventional vacuum chemical vapor deposition chamber:
pressure, 0.45 Torr;
helium flow 40 sccm through a bubbler containing
Ti(NR₂)₄; nitrogen flow, 100 sccm;
susceptor temperature 420°C.
An argon purge gas at 200 sccm was also used following the deposition.
Titanium nitride films were deposited at a deposition rate of about 425 angstroms per minute following the process of Sandhu et al. The resultant titanium nitride films were very uniform in thickness, having a four wafer thickness variation of only 3.03%. However, the sheet resistivity (average of four wafers) was high, 11,360 µohm-cm/sq.

Further, the resistivity was unstable. Fig. 2 is a graph of sheet resistivity in ohms/sq versus time in hours. The measurements denoted "A" (□) were taken from films withdrawn from the deposition chamber after the desired film thickness was obtained. The measurements denoted "B" (○) were taken from films cooled to a temperature of 150°C prior to removing them from the deposition chamber. Although the sheet resistivity of the "B" samples had a lower sheet resistivity, both samples were unstable and the sheet resistivity increased with time.

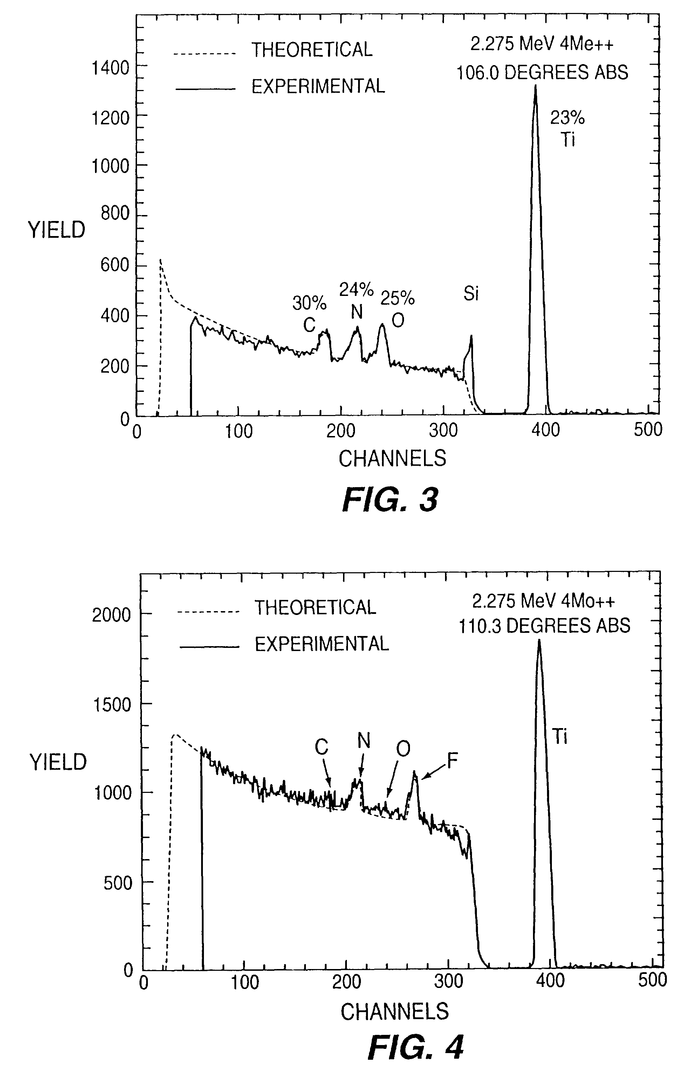

Rutherford backscattering measurements were made on a titanium nitride thin film made under the above conditions. The resultant spectrum is given in Fig. 3. The peaks for carbon, C, nitrogen, N, and oxygen, O, are marked on the spectrum, as is the silicon interface. The carbon content was determined to be about 30%, nitrogen content about 24%, oxygen content about 25%, and titanium about 23%. Thus the titanium nitride films contained comparatively high levels of carbon and oxygen impurities.

The deposition method was varied, particularly by adding various gases during deposition of the films in an effort to reduce the sheet resistivity. The results are given in Table I below. In the Table the Control film was deposited using the method given above.

**TABLE I**

| Example | Description | Thickness, Å | Resistivity, µΩ-cm |
|---|---|---|---|
| Control | | ∼500 | 16,000 |
| C1 | H₂ added | ∼500 | 81,200 |
| C2 | NF₃ added | ∼200 | 2,200 |
| C3 | H₂/NF₃ added | ∼400 | 1x10⁶ |
| C4 | mixed H₂N₂ added | ∼500 | 39,500 |

It is apparent that the most successful run from the point of view of reducing the sheet resistivity was obtained using a flow of NF₃ (7 sccm) during deposition, which reduced the sheet resistivity to 2200 µΩ-cm. However, as can be seen from the Rutherford backscattering spectra of that run set forth in Fig. 4, fluorine was incorporated as an impurity in the film, which is not desirable.

Thus pre- and post-deposition flow of gases and plasma treatment were tried to determine whether such treatment would affect the sheet resistivity; in two cases a plasma was initiated before and after chemical vapor deposition of titanium nitride using a low power of 100 watts and without biasing the substrate silicon wafer. The results are summarized in Table II below.

**TABLE II**

| Sample | Description | Thickness, Å | Resistivity, µΩ-cm |
|---|---|---|---|
| C5 | H₂ plasma pre/post | ∼500 | 13,500 |
| C6 | N₂ plasma pre/post | ∼500 | 15,500 |
| C7 | NF₃ flow prior to deposition | ∼500 | 16,500 |

It is apparent that none of these pre- and post-treatments had much effect on the sheet resistivity.

Thus it was highly unexpected that when a bias voltage was applied to the substrate in a plasma, the sheet resistivity markedly decreased, and, more importantly, remained stable over time.

The invention will be further described by means of the following examples, but the invention is not meant to be limited to the details described therein.

### Examples 1-8

A series of tests were conducted applying a bias voltage of 400 volts to a silicon wafer substrate having a layer of titanium nitride thereon, deposited in the chamber of Fig. 1 at an applied RF power of about 100 watts. Deposition and biasing were performed sequentially. The two steps were cycled up to five times. A Summary of deposition thickness, number of cycles and resistivities obtained over time are given below in Table III, wherein the Control B was deposited in five interrupted steps, but without forming a plasma between depositions.

**TABLE III**

| Sample # of Cycles | | Thickness pr cycle | Power, watts | Time, sec | Total Thickness, Å | Resistivity | | |
|---|---|---|---|---|---|---|---|---|
| | | | | | | Initial | After 24 hrs | Δ, % |
| Control | 5 | 100 | -- | -- | 226 | 11,020 | 25,385 | 130 |
| Ex. 1 | 2 | 500 | 100 | 30 | 731 | 4,620 | 6,623 | 43 |
| Ex. 2 | 3 | 333 | 100 | 30 | 707 | 2,870 | 3,627 | 26 |
| Ex. 3 | 4 | 250 | 100 | 30 | 654 | 2,027 | 2,662 | 31 |
| Ex. 4 | 2 | 500 | 100 | 60 | 579 | 2,762 | 3,827 | 39 |
| Ex. 5 | 3 | 333 | 100 | 60 | 604 | 2,150 | 2,549 | 19 |
| Ex. 6 | 4 | 250 | 100 | 60 | 606 | 1,630 | 1.915 | 17 |
| Ex. 7 | 5 | 100 | 100 | 30 | 376 | 1,154 | 1,203 | 4 |
| Ex. 8 | 5 | 50 | 100 | 30 | 220 | 913 | 933 | 2 |

Thus titanium nitride resistivity can be markedly reduced and stability dramatically improved, e.g., a 2% increase in resistivity over 24 hours, by a post treatment of titanium nitride films applying a bias voltage to the substrate in a nitrogen or other plasma.

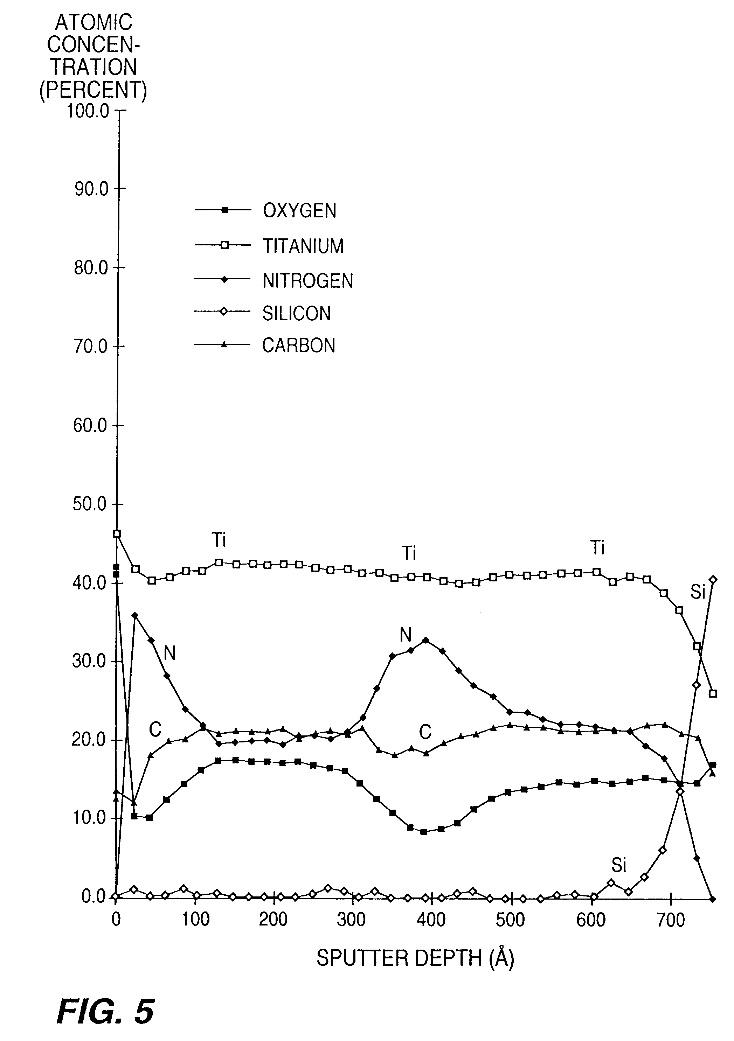

Fig. 5 is a graph of atomic concentration in % of elements versus sputter etch depth in angstroms of an Auger analysis of titanium nitride film of Example 1. This film was biased twice for 30 seconds, see Table III above.

Referring to Fig. 5, the titanium concentration remained steady, but the graph clearly shows that at the film surface nitrogen concentration is high and carbon and oxygen concentrations are low. This reduction in impurity levels continued for a depth of about 100 angstroms. At 400 angstroms depth, when the film was treated with high energy ions first, again the nitrogen concentration rises and carbon and oxygen concentrations decrease. Thus the graph of Fig. 5 clearly shows a change in the elemental composition of the films after treatment in accordance with the invention.

The change in elemental analysis with depth is shown in Table IV below:

**TABLE IV**

| Depth, Å | O₂, % | N₂, % | C, % |
|---|---|---|---|
| 42 | 9.8 | 32.4 | 18.1 |
| 188 | 17.2 | 20.0 | 20.9 |
| 397 | 8.2 | 32.6 | 18.6 |
| 543 | 14.3 | 22.8 | 21.9 |

Since a 100 angstrom thick layer of titanium nitride is adequate for a barrier layer, the present post-deposition treatment is ideal for improving the stability and reducing the resistivity of titanium nitride barrier layers about 100 angstroms thick.

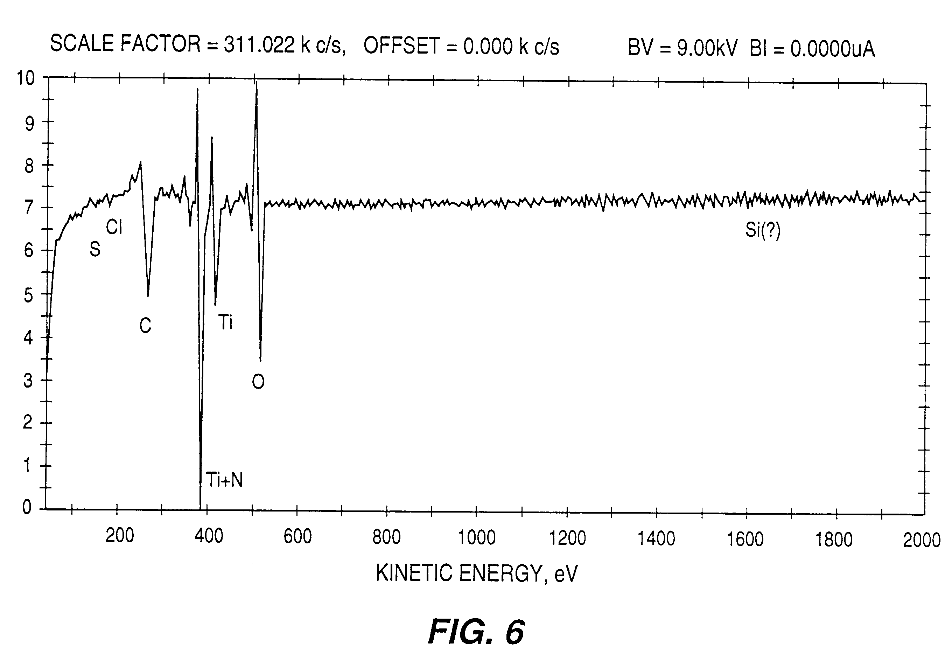

An Auger spectrum showing surface elements present on the post treated film of Example 7 is shown in Fig. 6. This spectrum shows that the bulk of the material deposited is titanium nitride with some titanium present, and carbon and oxygen are present at the surface as impurities.

However, Auger sputtering analysis of the film, as shown in Fig, 7, shows that the oxygen concentration dropped markedly in the bulk of the film to a low level. Carbon is the only other major impurity, and remains unaffected by the present process.

At a depth of 200 Å, the concentration of various elements in atomic percent were: oxygen, 2.8%; carbon, 20.9%; titanium 38.8%; and nitrogen 37.5%. No silicon was present.

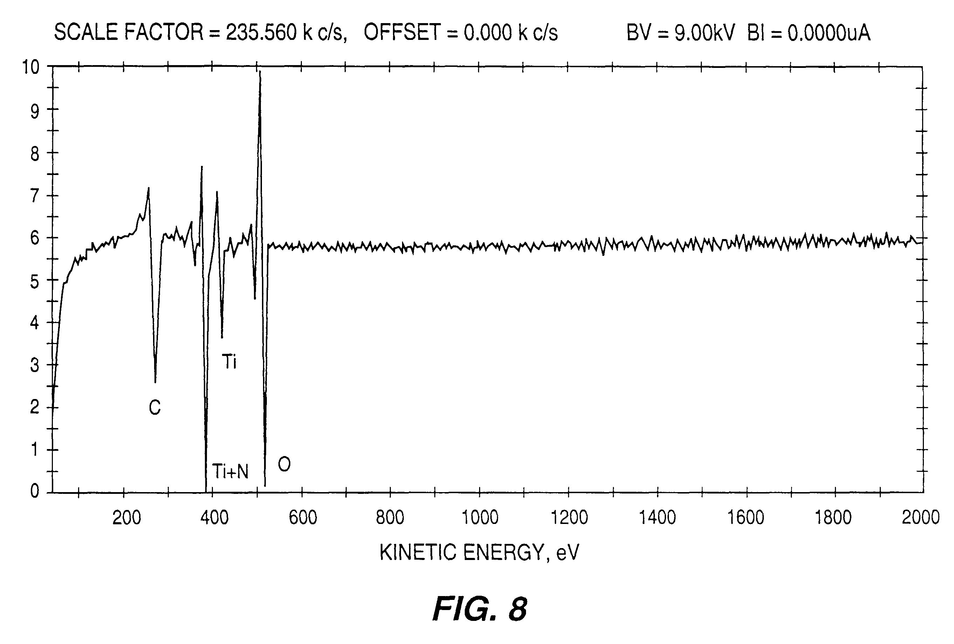

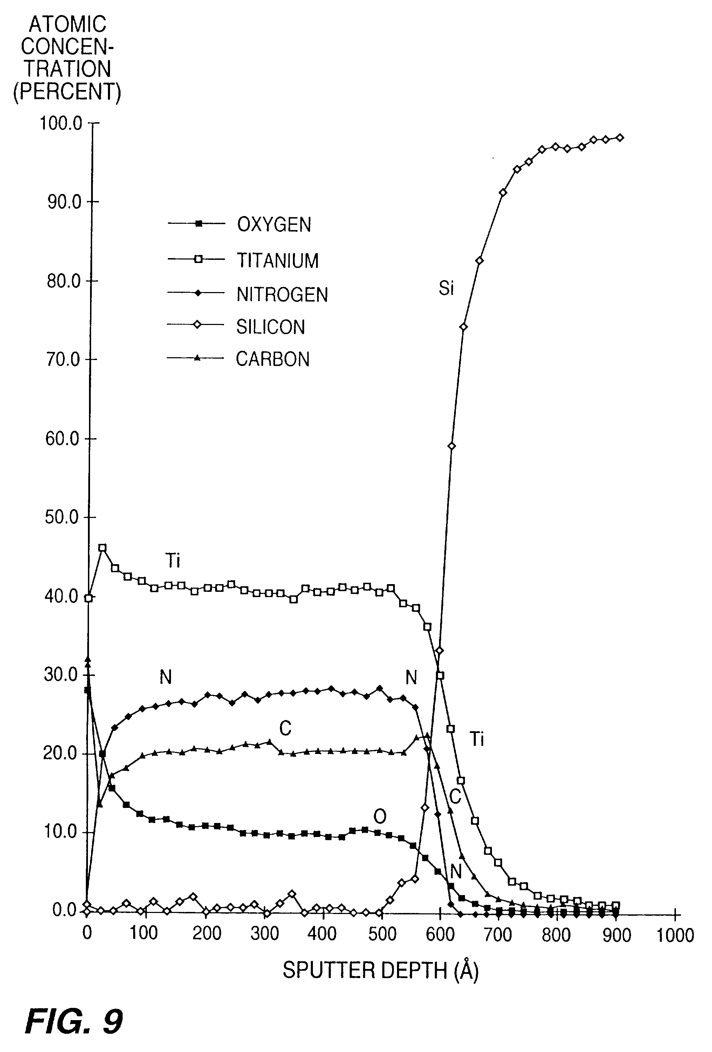

As a comparison, surface Auger analysis of the Control film is shown in Fig. 8 and sputter Auger analysis of the Control film is shown in Fig. 9. The oxygen content of this film was somewhat higher. At 200 Å depth, the concentration of elements in atomic % were: oxygen, 10.8%; carbon, 20.7%; titanium 41.0% and nitrogen 27.5%. No silicon was present.

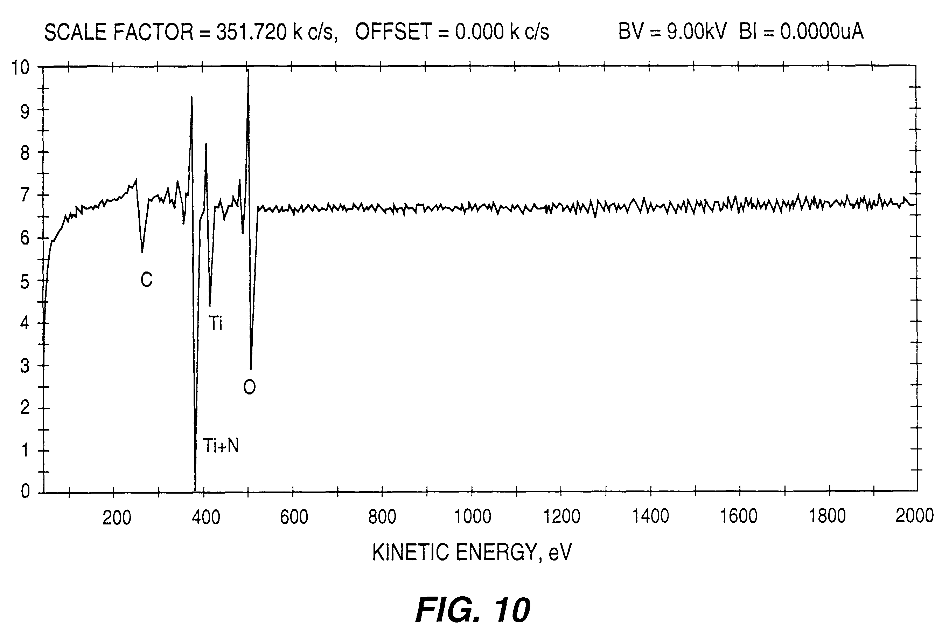

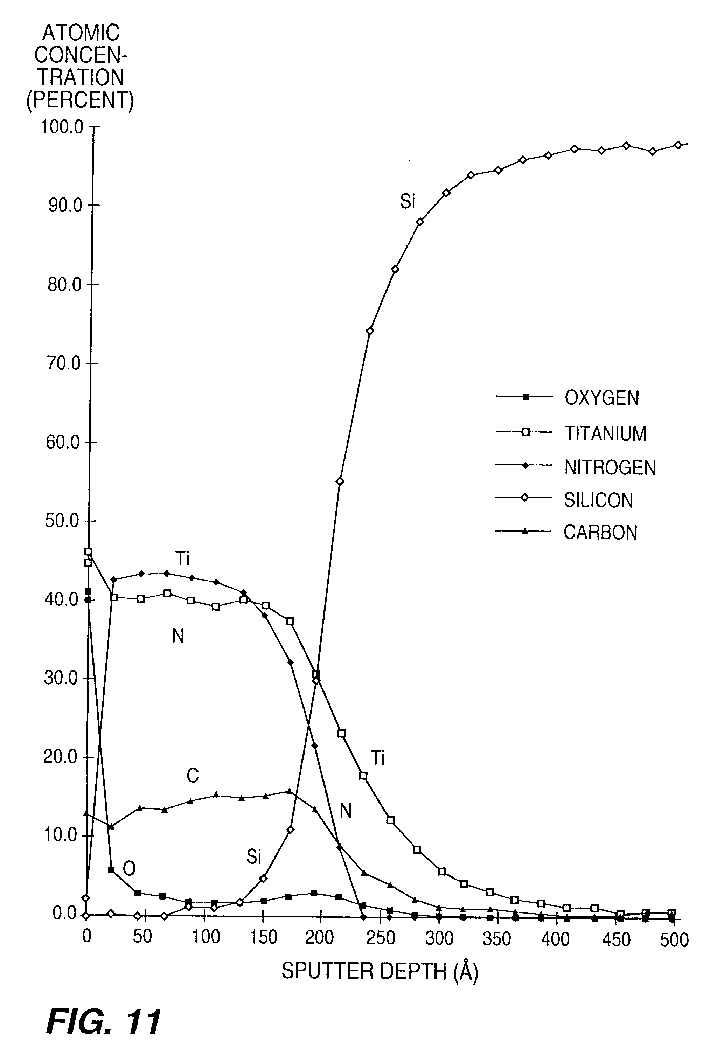

Surface Auger analysis of the titanium nitride film of Example 8 is shown in Fig. 10 and sputter Auger analysis versus depth in angstroms is shown in Fig. 11. The oxygen content of this film was low. At 43 angstroms depth, the elemental concentration in atomic % was: oxygen, 3.1%; carbon, 13.7%; titanium, 40.0% and nitrogen, 43.2%. No silicon was present.

RBS was used to determine the density in atoms/cm³ of titanium nitride deposited films. The data is summarized below in Table V:

**TABLE V**

| | |
|---|---|
| Control | 3.48 x 10cm⁻³ |
| Example 7 | 3.96 x 10cm⁻³ |
| Example 8 | 3.94 x 10cm⁻³ |

Thus plasma treatment and bombardment with high energy ions increased the density of the titanium nitride films as compared to the Control.

The present invention is not meant to be limited to titanium nitride barrier layers and the post deposition bias voltage in a plasma treatment of the invention can serve to improve properties and chemical composition of other materials as well, including CVD aluminum, copper, sputtered aluminum tantalum, tantalum pentoxide, silicides, other nitrides and the like. Although the present invention was exemplified by a titanium nitride film on a silicon wafer, other substrates can be employed such as stainless steel, metals such as titanium, aluminum and tungsten, and oxides such as titanium oxide, silica, glasses and the like, and silicides such as titanium silicide.

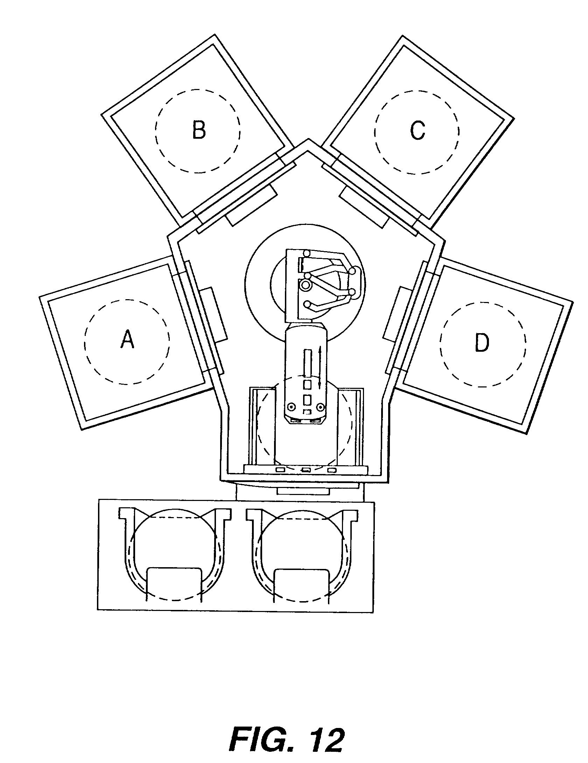

The deposition and post plasma/voltage treatment can be performed in a single CVD chamber fitted with a precursor gas and plasma capability, such as is described with respect to Fig. 1. Alternatively, more than one chamber can be employed. The layer to be treated can be deposited in a CVD chamber, and the substrate transferred to a plasma clean chamber, such as an adjacent plasma chamber, where the post plasma/power treatment of the invention can be performed. Preferably, vacuum is maintained during the transfer of the substrate from the CVD chamber to a plasma chamber. A multichamber vacuum system suitable for carrying out the present invention is disclosed by Maydan et al in US Patent 4,961,601, incorporated herein by reference. Such a system is shown schematically in Fig. 12. Ideally the substrate will be precleaned in a pre-clean chamber A, the substrate transferred to a CVD chamber B where a film is deposited onto the substrate, and the substrate having the desired layer thereon subsequently transferred to a post plasma/power treatment chamber C, all without removing the coated substrate from a vacuum environment.

In the case where titanium nitride barrier layers are to be "stuffed" with oxygen controllably, as is disclosed in copending application SN 08/087,081 to Ngan et al, such step can be carried out after the plasma/power treatment step in a chamber D.

Although the above application has been described primarily in terms of post deposition treatment of titanium nitride films deposited by chemical vapor deposition, one skilled in the art can readily vary parameters of starting materials and deposited films, deposition and post treatment reaction conditions and the like.

## Claims

1. A method of improving the film properties of a film deposited on a substrate, comprising
bombarding the film with energetic ions.

2. A method of changing the film properties of a film on a substrate, comprising
depositing said film on said substrate in a vacuum environment and, without removing from the vacuum environment,
exposing the film to a plasma of a precursor gas while applying a bias voltage to said substrate.

3. A method according to claim 2, wherein said film is titanium nitride.

4. A method according to claim 2 or claim 3, wherein said film is deposited by thermal decomposition of a metallo-organic titanium compound.

5. A method according to claim 4, wherein said metallo-organic titanium compound has the formula 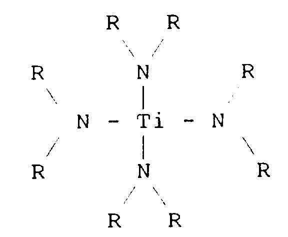 wherein R independently at each occurrence is an alkyl group.

6. A method according to any one of claims 2 to 5, wherein said gas is nitrogen or ammonia.

7. A method according to any one of claims 2 to 6, wherein a bias voltage of in the range of from about 100 to 1000 volts is applied to said substrate.

8. A method according to any one of claims 2 to 7, wherein said substrate is a semiconductor substrate.

9. A method according to any one of claims 2 to 8, wherein the change to the film is an improvement in resistivity and stability of the film.

10. A semiconductor device comprising a film on a substrate, wherein the film properties of the film have been changed according to the method of any one of claims 2 to 9.
